Europäisches Patentamt

European Patent Office

Office européen des brevets

(11) Numéro de publication: **0 269 478**
**A1**

## (12) DEMANDE DE BREVET EUROPEEN

(21) Numéro de dépôt: 87402342.7

(22) Date de dépôt: 20.10.87

(51) Int. Cl.⁴: **H 05 K 13/00**

(30) Priorité: 24.10.86 FR 8614834

(43) Date de publication de la demande:
01.06.88 Bulletin 88/22

(84) Etats contractants désignés:
DE FR GB IT NL SE

(71) Demandeur: OREGA ELECTRONIQUE & MECANIQUE
74, rue du Surmelin
F-75020 Paris (FR)

(72) Inventeur: Baguet, Brigitte
THOMSON-CSF SCPI 19, avenue de Messine
F-75008 Paris (FR)

Fourcault, Jean-Paul
THOMSON-CSF SCPI 19, avenue de Messine
F-75008 Paris (FR)

(74) Mandataire: Chaverneff, Vladimir et al
THOMSON-CSF SCPI 19, avenue de Messine
F-75008 Paris (FR)

(54) **Plateau de transport de modules électroniques, en particulier de modules comportant une ceinture ou une enveloppe de blindage et un connecteur à broches.**

(57) Le plateau (1) conforme à l'invention comporte plusieurs alvéoles (2) à parois légèrement inclinées pour faciliter l'introduction automatique des modules (3).

Une cavité (6) est prévue pour le logement des broches (4) du connecteur des modules. Le module repose, par sa ceinture de blindage, sur des épaulements (12 , 13) de l'alvéole.

# FIG_1

EP 0 269 478 A1

**Description**

PLATEAU DE TRANSPORT DE MODULES ELECTRONIQUES, EN PARTICULIER DE MODULES COMPORTANT UNE CEINTURE OU UNE ENVELOPPE DE BLINDAGE ET UN CONNECTEUR A BROCHES.

La présente invention se rapporte à un plateau de transport de modules électroniques, en particulier de modules comportant une ceinture ou une enveloppe de blindage et un connecteur à broches.

Pour convoyer sur une ligne de production des circuits imprimés munis de connecteurs à broches, tels que des circuits de "tuners" VHF/UHF, depuis la séparation des circuits en plaque (généralement, les petits circuits imprimés sont fabriqués à partir d'une grande plaque sur laquelle plusieurs de ces circuits sont gravés) jusqu'à leur palettisation, et pour transporter les palettes comportant un grand nombre de circuits équipés de leurs composants jusqu'au lieu de montage de ces circuits sur des platines d'appareils (dans la même usine ou dans une autre), on utilisait jusqu'à présent des cadres à rainures dans lesquels on glissait manuellement en ayant souvent à vaincre des frottements non négligeables, et un par un, ces circuits sur les broches de connecteurs desquels on devait enficher des protège-connecteurs. Un tel procédé n'était pas automatisable, risquait d'endommager les circuits et/ou leurs composants, en particulier les broches des connecteurs, et ne permettait pas d'utiliser au mieux le volume utile des palettes de transport.

La présente invention a pour objet un plateau de transport de modules électroniques sur lequel ces circuits puissent être mis en place par des moyens automatiques et y soient maintenus à l'abri des chocs, et tel que, le cas échéant, les broches due connecteur de ces modules ne nécessitent pas de protège-connecteur, ce plateau pouvant être empilé avec des plateaux semblables en offrant le meilleur coefficient de remplissage possible des cartons de transport dans lequels plusieurs de ces plateaux sont empilés avec leurs modules, un tel plateau étant de faible prix de revient, longtemps réutilisable, et facilement manipulable.

Le plateau conforme à l'invention comporte plusieurs alvéoles alignés dont les parois s'évasent légèrement vers l'ouverture, dont le fond comporte des formes complémentaires de celles de l'une des faces des modules, et le cas échéant, une cavité pour le logement des broches du connecteur, la face inférieure de ce plateau comportant des formes sensiblement complémentaires des formes des faces supérieures des parois des alvéoles pour permettre l'empilage de plateaux.

La présente invention sera mieux comprise à la lecture de la description détaillée d'un mode de réalisation, pris à titre d'exemple non limitatif et illustré par le dessin annexé, sur lequel:

- la figure 1 est une vue de côté, partiellement en coupe, d'un plateau conforme à l'invention,

- la figure 2 est une vue de détail, en perspective, du plateau de la figure 1,

- la figure 3 est une vue partielle, en partie en coupe, du plateau de la figure 1, montrant l'empilement avec un autre plateau, et

- la figure 4 est une vue partielle de dessous en perspective du plateau de la figure 1.

Le plateau de transport décrit ci-dessous est destiné au transport et à la manipulation de "modules" miniaturisés de tuners VHF/UHF de récepteurs de télévision. Ces "modules" sont des circuits imprimés munis de tous leurs composants, enfermés dans un boîtier de blindage ou comportant simplement une ceinture de blindage, et comportant un connecteur de connexion fixé au bord de l'un des côtés de la carte du circuit imprimé, dont les broches, relativement fragiles, s'étendent vers l'extérieur de la carte, parallèlement à celle-ci. Toutefois, il est bien entendu que l'invention n'est pas limitée à un tel genre de circuits imprimés, et peut s'appliquer à la manipulation et au transport de divers types de circuits imprimés, ou autres sous-ensembles avec ou sans boîtier de blindage, avec ou sans connecteur à broches.

Le plateau 1 a, en vue de dessus, un périphérie rectangulaire. Il est normalement utilisé en position horizontale. Il comporte plusieurs alvéoles identiques 2 s'étendant côte à côte, transversalement au plan médian longitudinal du plateau 1, par exemple vingt alvéoles pour l'utilisation précitée. Ces alvéoles sont destinés à recevoir chacun un module 3. Les modules 3 ont la forme générale de parallélépipèdes rectangles, relativement plats. Ces modules 3 comportent, en saillie sur une de leurs faces (celle bordée par deux des plus longs et deux des plus courts côtés du parallélépipède), des broches 4 de connecteur.

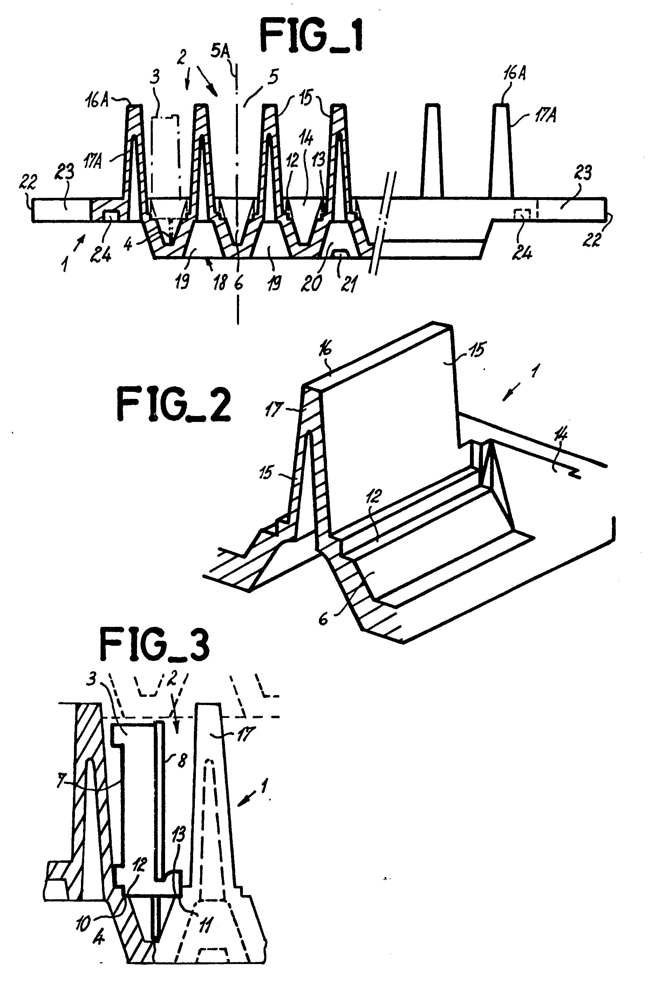

Chaque alvéole 2 comporte une première cavité 5 pour le logement du module proprement dit, et une deuxième cavité 6 pour le logement des broches 4, pratiquée dans le fond de la cavité 5. Les cavités 5 sont symétriques par rapport à un plan de symétrie perpendiculaire à l'axe longitudinal du plateau 1. On a représenté sur la figure 1 la trace 5A d'un tel plan de symétrie. Ainsi, on peut présenter les plateaux par l'une quelconque de leurs extrémités sur un convoyeur de chargement (ces plateaux sont disposés sur le convoyeur de façon que leur axe longitudinal conïncide sensiblement avec l'axe longitudinal du convoyeur), et les modules seront toujours bien disposés dans les cavités 5. Les modules 3 sont disposés "debout" dans les alvéoles 2, c'est-à-dire que leurs deux faces latérales 7 , 8 les plus grandes sont perpendiculaires au plan médian longitudinal du plateau, tandis que leur face latérale 9, de laquelle font saillie les broches 4 est en bas et repose, par ses rebords 10 , 11 (bordés par deux des arêtes les plus longues de ces modules) sur des épaulements 12 , 13 formant le fond de la cavité 5. Les formes des épaulements 12 , 13 sont complémentaires de celles des coins inférieurs des modules. Dans le cas présent, ces coins étant déterminés par deux surfaces orthogonales, les épaulements 12 , 13 le sont aussi.

Les cavités 6 ont des dimensions supérieures à celles des broches 4 de façon que ces broches n'en touchent les parois à aucun moment de la mise en place des modules 3 dans les alvéoles 2, même si ces modules ne sont pas déposés correctement du premier coup et qu'ils descendent légèrement en biais dans les alvéoles 2.

Dans le cas présent, les cavités 5 sont délimitées, latéralement, par quatre cloisons planes à faces parallèles : deux cloisons 14 (une seule d'entre elles étant représentée sur le dessin pour chaque cavité, le dessin étant en coupe longitudinale) sensiblement parallèles au plan médian longitudinal (plan de symétrie) du plateau 1, et deux cloisons 15 sensiblement perpendiculaires à ce plan. Les cloisons 15 sont plus hautes que les cloisons 14, puisqu'elles sont nécessaires et suffisantes pour assurer, comme expliqué ci-dessous, l'espacement correct entre plateaux empilés (voir figure 3). Ces cloisons 14 et 15 font un faible angle par rapport à la verticale (les plateaux étant considérés disposés sur un plan horizontal), ce qui fait que les cavités 5 s'évasent légèrement vers le haut, afin de faciliter l'introduction des modules. La face supérieure 16 de chaque paroi séparatrice 17, formée par deux cloisons 15 adjacentes se joignant à leur sommet en formant un "V" renversé (du fait que ces parois sont légèrement inclinées par rapport à la verticale), ainsi que la face supérieure 16A des deux parois extrêmes 17A relatives aux cavités 5 extrêmes du plateau, sont planes et horizontales (le plateau 1 étant sur un plan horizontal). Ces faces 16 et 16A, toutes coplanaires, sont légèrement au-dessus du plan des faces supérieures des modules 3 lorsque ceux-ci sont en place dans leurs alvéoles respectifs.

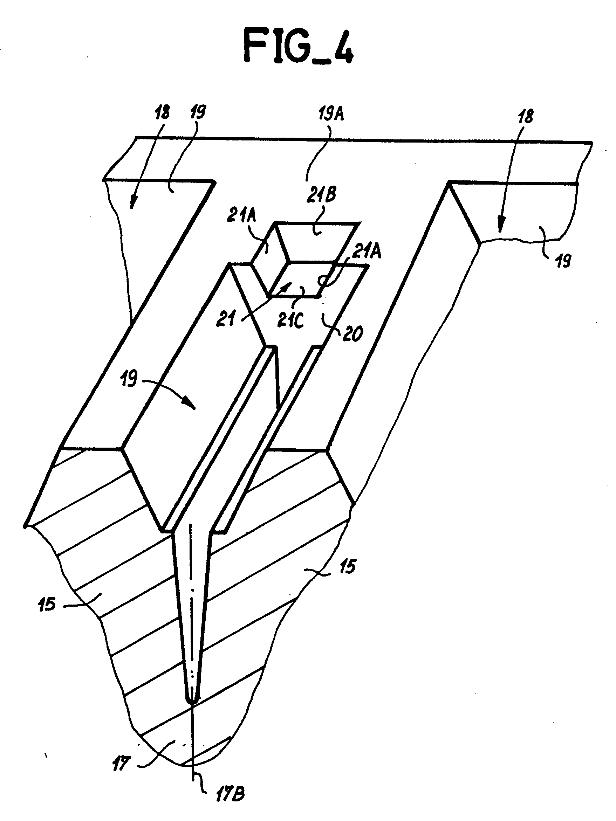

Pour économiser de la matière et pouvoir bien maintenir en place des plateaux superposés, on évide la face inférieure des plateaux dans la base, suffisamment large, des parois 17 en formant des cavités 18, qui ont ainsi des cloisons communes avec les cavités 6 avec lesquelles elles alternent. Les cavités 18 on sensiblement la même profondeur que les cavités 6. Ces cavités 18 son bordées, à leurs extrémités, considérées dans leur sens longitudinal, par des cloisons 19. La largeur des parois 17 à leur partie supérieure étant légèrement inférieure à la distance entre faces se faisant vis-à-vis des cloisons 19, les cavités 18 d'un plateau viennent "coiffer" les sommets des parois 17 d'un autre plateau lorsque le premier plateau est en correspondance sur l'autre. Toutefois, afin de limiter au strict nécessaire l'enfoncement d'un plateau sur un autre (c'est-à-dire pour que les faces 16, 16A des parois 17, 17A ne viennent pas en butée contre les fonds des cavités 18, et afin de bien positionner les plateaux l'un au-dessus de l'autre (la largeur des cavités 18 étant plus grande que l'épaisseur de la partie supérieure des parois 17), on augmente, vers l'intérieur, l'épaisseur de certaines des parois 19. On peut par exemple augmenter l'épaisseur des parois 19A relatives à deux cavités 18 proches chacune d'une extrémité du plateau 1. Cette augmentation d'épaisseur est telle que la distance entre les faces 20 se faisant vis-à-vis des parois épaissies 19A d'une même cavité soit intérieure à la longueur des faces 16. En outre, on pratique dans la face inférieure de ces parois épaissies des rainueres transversales 21, symétriques par rapport au plan de symétrie des parois 17 (on a représenté sur la figure 4 la trace 17B de ce plan). La section, selon un plan perpendiculaire audit plan de symétrie, des rainures 21 est trapézoïdale, ces rainures s'évasant vers le bas du plateau et formant des genres de trémies assurant un meilleur guidage des parties supérieures des parois 17 correspondantes qui viennent s'y loger (voir figure 3). Les parois 21C formant les fonds des rainures 21 font butées pour les extrémités des faces 16 du plateau de dessous. Les faces latérales 21A des rainures 21 positionnent les plateaux dans le sens de leur axe longitudinal, et les faces frontales 21B des rainures 21 positionnent ces plateaux transversalement lorsqu'on les empile. La largeur des rainures 21 au niveau du fond 21C est, bien entendu, sensiblement égale à celle des faces 16 et leur profondeur est telle que lorsque l'on superpose en correspondance deux plateaux, les faces inférieures des cloisons inférieures des cavités 6 soient légèrement au-dessus des faces supérieures des modules 3 lorsque ces derniers sont en place dans les alvéoles du plateau de dessous.

Un plateau 1 comporte à ses extrémités des poignées de manipulation 22, qui peuvent par exemple être simplement de forme rectangulaire en constituant les prolongements des extrémités du plateau. De façon avantageuse, les faces frontales de poignées 22 comportent en leur milieu une rainure verticale de guidage 23 (c'est-à-dire qui a pour plan de symétrie le plan de symétrie longitudinal du plateau 1), rainure dans laquelle peut passer un lien souple entourant une pile de plateaux, et qui empêche ce lien de glisser. Un tel lien souple repose de façon souple sur les produits du plateau supérieur de la pile afin de ne pas les endommager et évite l'utilisation d'un couvercle sur le dessus de la pile.

Les plateaux de l'invention peuvent être réalisés facilement par moulage d'un matériau synthétique tel que de la matière plastique, qui peut avantageusement être antistatique pour éviter l'accumulation d'électricité statique sur les modules.

Selon une autre caractéristique de l'invention, les plateaux sont de couleurs différentes pour faciliter la reconnaissance visuelle des modules qu'ils contiennent : à des types différents de modules on associe des couleurs différentes de plateaux. On peut également effectuer un marquage, par exemple à l'aide d'un dispositif marqueur à laser, sur l'un des côtés latéraux des plateaux et/ou sur leurs faces 17A, d'une référence, par exemple sous forme d'un code à barres et/ou d'un code alphanumérique, qui peut être lu par simple passage des plateaux sous une tête de lecture convenablement orientée et qui facilite le suivi des plateaux et la gestion de la production.

Pour bien positionner et immobiliser le cas échéant les plateaux sur un convoyeur, on pratique dans les faces inférieures de leurs poignées 22 des petites cavités 24. On pratique avantageusement une cavité pour chaque poignée, les deux cavités d'un même plateau étant disposées symétriquement par rapport à l'axe longitudinal du plateau. Des broches rétractables du convoyeur (non représentées) pénètrent dans ces cavités lorsque les plateaux sont déposés sur le convoyeur. Bien entendu, les plateaux sont déposés de la façon la plus précise possible sur le convoyeur afin que lesdites broches puissent pénétrer à coup sûr dans ces cavités qui s'évasent légèrement vers leur ouverture. Bien entendu, au lieu des cavités et des broches, on peut munir le convoyeur de tout moyen de positionnement approprié des plateaux par rapport au convoyeur.

En conlusion, les plateaux conformes à l'invention facilitent grandement les opérations de manipulation et de transport des produits que l'on y dépose et permettent d'automatiser ces opérations. L'ouverture légèrement cônique des alvéoles permet d'y introduire facilement les produits, et dans le cas où les produits en question sont des modules de circuits imprimés à broches de connexion fragiles, la mise en place des modules se fait sans dommage pour les broches, les parois en pente des alvéoles guidant le module dont les broches du connecteur sont protégées par la cavité inférieure des alvéoles sans entrer en contact avec ses parois car les modules reposent sur la "ceinture" de leur blindage. De plus, si les modules comportent des composants légers, leurs connecteurs, qui se trouvent à leur extrémité inférieure lorsqu'ils sont sur les plateaux, et qui constituent les éléments les plus lourds fixés sur les circuits imprimés, déplacent le centre de gravité des modules vers leur partie inférieure (le blindage disposé régulièrement tout autour n'intervenant pratiquement pas). Par conséquent, si un module était mal positionné dans son alvéole, la moindre secousse appliquée au plateau suffirait à placer correctement le module sans qu'on le touche. La précision du positionnement des modules sur le plateau est fonction de la tolérance des dimensions hors-tout de leur ceinture ou enveloppe de blindage, et de la tolérance sur l'emplacement des épaulements 12 supportant les modules. Cette précision peut être suffisante pour rendre possibles des opérations automatisées sur les modules telles que le marquage au jet d'encre sur la face supérieure du blindage des modules sans nécessiter de manipulation particulière des modules.

Le faible poids des plateaux, leur maniabilité et leurs petites dimensions sont adaptés à une manipulation automatique de grande cadence. Les piles de plateaux peuvent facilement avoir des dimensions correspondant aux dimensions standardisées des cartons d'emballage, ce qui évite l'emploi de cales dans ces cartons.

**Revendications**

1. Plateau de transport de modules électroniques, en particulier de modules comportant une ceinture ou une enveloppe de blindage et un connecteur à broches, caractérisé par le fait qu'il comporte plusieurs alvéoles alignés (2) dont les parois s'évasent légèrement vers l'ouverture, dont le fond comporte des formes (12 , 13) complémentaires de celles de l'une des faces des modules (10 , 11) et, le cas échéant, une cavité (6) pour le logement des broches (4) du connectuer, la face inférieure de ce plateau comportant des formes (20 , 21) sensiblement complémentaires des formes des faces supérieures (16) des parois (15) des alvéoles pour permettre l'empilage de plateaux.

2. Plateau selon la revendication 1, caractérisé par le fait que les alvéoles sont symétriques par rapport à un plan (5A) perpendiculaire à l'axe longitudinal de plateau.

3. Plateau selon l'une quelconque des revendications 1 ou 2, caractérisé par le fait qu'il comporte à sa face inférieure des rainures (21) coopérant avec les faces supérieures (16) de parois de cavités (17) correspondantes d'un autre plateau sur lequel il est empilé (figure 3).

4. Plateau selon l'une quelconque des revendications précédentes, caractérisé par le fait qu'il comporte à ses extrémités des poignées (22).

5. Plateau selon la revendication 4, caractérisé par le fait qu'on pratique des rainures (23) sur les faces frontales des poignées, pour le guidage de liens entourant une pile de plateaux.

6. Plateau selon l'une quelconque des revendications précédentes, caractérisé par le fait qu'on réalise plusieurs plateaux de couleurs différentes auxquels on associe des modules de types différents.

7. Plateau selon l'une quelconque des revendications précédentes, caractérisé par le fait que l'on effectue un marquage d'une référence sur l'un des côtés latéraux du plateau et/ou sur ses poignées.

8. Plateau selon l'une quelconque des revendications précédentes, caractérisé par le fait que les plateaux sont en matière antistatique.

9. Plateau selon l'une quelconque des revendications précédentes, disposé sur un convoyeur, caractérisé par le fait que le convoyeur comporte des moyens de positionnement de ce plateau.

10. Plateau selon la revendication 9, caractérisé par le fait que lesdits moyens de positionnement sont des broches rétractables s'enfonçant dans des cavités (24) pratiquées dans la face inférieure du plateau.

## FIG_1

## FIG_2

## FIG_3

0269478

## FIG_4

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | PATENT ABSTRACTS OF JAPAN, vol. 8, no. 119 (E-248)[1556], 5 juin 1984; & JP-A-59 32 155 (HITACHI SEISAKUSHO K.K.) 21-02-1984 * Alinéa 1; figure * --- | 1-4 | H 05 K 13/00 |
| Y | IBM TECHNICAL DISCLOSURE BULLETIN, vol. 23, no. 3, août 1980, pages 1040-1041, new York, US; J.L. NAPOLI: "Rubber module stop" * page 1040, alinéa 1; figure * --- | 1-4 | |
| A | GB-A-1 136 294 (IBM) * Page 3, lignes 15-23; figures 1-3,7,9,10 * --- | 1-3,9 | |
| A | EP-A-0 038 179 (FUJITSU) * Page 3, ligne 22 - page 4, ligne 37; figure 7 * ----- | 1,2,4,7,8 | |
|  |  |  | **DOMAINES TECHNIQUES RECHERCHES (Int. Cl.4)** |
|  |  |  | H 05 K 13/00 |

Le présent rapport a été établi pour toutes les revendications

| Lieu de la recherche | Date d'achèvement de la recherche | Examinateur |
|---|---|---|
| LA HAYE | 01-02-1988 | TIELEMANS H.L.A. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
................................................................
& : membre de la même famille, document correspondant

EPO FORM 1503 03.82 (P0402)